# EUROPEAN PATENT APPLICATION

(11) **EP 4 831 117 A1**
(43) Date of publication of application: **28.10.2026**
(21) Application number: 24906864.4
(22) Date of filing: 03.10.2024
(51) Int. Cl.: C01B 21/064, C08K 3/38, C08L 101/00

(54) **PRODUCTION METHOD FOR BORON NITRIDE PARTICLES, PRODUCTION METHOD FOR RESIN COMPOSITION, AND USES THEREFOR**

(30) Priority: 18.12.2023 JP 2023213371
(71) Applicant: Resonac Corporation, Tokyo 105-7325 (JP)
(72) Inventor: FUKASAWA, Masaru, Tokyo 105-7325 (JP); YOKOYAMA, Yasunori, Tokyo 105-7325 (JP)
(74) Representative: Hoffmann Eitle
(86) International application number: PCT/JP2024/035516
(87) International publication number: WO 2025/134475

(57) **Abstract**

The present disclosure aims to provide a novel method of producing a boron nitride particle, whereby a boron nitride particle having low dielectric properties and high thermal conductivity can be produced, a method of producing a resin composition, which includes this method, and uses thereof. The method of producing a boron nitride particle of the present disclosure includes a step of nitriding a boron-containing particle containing boron atoms in a nitrogen gas atmosphere.

## Description

### Technical Field

The present disclosure relates to a method of producing a boron nitride particle, a method of producing a resin composition, and uses thereof.

### Background Art

The amount of transmission loss that occurs when radio waves transmitted for communication are converted into heat in dielectrics is expressed as the product of frequency, the square root of the relative permittivity, and the dielectric loss tangent. In other words, transmission signals have a tendency to turn into heat that is proportional to the frequency. Therefore, reduction of transmission loss at a higher frequency band requires that the materials used in communication members have lower dielectric properties.

In the field of information and communication, radio waves are becoming increasingly higher in frequency as the number of channels and the amount of information transmitted increase. Currently, studies on the fifth-generation mobile communication system are being conducted worldwide, and several frequency bands in the range of about from 30 GHz to 70 GHz have been proposed as candidates for use. In this regard, for the sixth-generation and subsequent mobile communication systems, still higher frequencies will be used. Thus, materials with low dielectric properties will be required to reduce transmission loss.

In addition, high thermal conductivity is required for sealing materials for semiconductor devices, interlayer insulating materials, copper-clad laminated plates, heat dissipation sheets, and the like.

Boron nitride is known as an inorganic filler having a low dielectric constant and high thermal conductivity. For example, a granulated powder is known, which includes spherical secondary particles formed by agglomerating primary particles, and in which the primary particles are scale-shaped boron nitride pieces, and in which each secondary particles has a core that includes the center of the secondary particle and a shell that covers the core, and in which the density of the primary particles in the core is lower than the density of the primary particles in the shell (see, for example, Patent Document 1).

### Prior Art Document

### Patent Document

Patent Document 1: Japanese Patent No. 6413478

### SUMMARY OF INVENTION

### Problem to be Solved by Invention

As described above, in the fields of semiconductor devices, low dielectric properties and high thermal conductivity are desired, and novel production methods that can produce boron nitride having low dielectric properties and high thermal conductivity are desired.

An object of the present disclosure is to provide a novel method of producing a boron nitride particle, whereby a boron nitride particle having low dielectric properties and high thermal conductivity can be produced, a method of producing a resin composition, which includes this method, and uses thereof.

### Means for Solving the Problem

Specific means for solving the problem are as follows:
<1> A method of producing a boron nitride particle, the method including a step of nitriding a boron-containing particle containing boron atoms in a nitrogen gas atmosphere.
<2> The method of producing a boron nitride particle according to <1>, wherein the boron-containing particle is nitrided at a pressure of from 1 to 20 atm.
<3> The method of producing a boron nitride particle according to <1> or <2>, wherein the boron-containing particle is nitrided under heating conditions of from 1500°C to 2200°C.
<4> The method of producing a boron nitride particle according to any one of <1> to <3>, wherein the boron-containing particle includes at least one selected from the group consisting of a boron particle and boron carbide.
<5> The method of producing a boron nitride particle according to any one of <1> to <4>, wherein the produced boron nitride particle comprises a core that contains boron nitride and a shell that covers at least a part of the core and contains boron nitride, and the core and the shell have anisotropy.
<6> The method of producing a boron nitride particle according to <5>, wherein the core contains boron nitride oriented in a direction intersecting the outer periphery of the particle, and the shell contains boron nitride oriented along the outer periphery of the particle.
<7> The method of producing a boron nitride particle according to any one of <1> to <6>, wherein the boron-containing particle has an aspect ratio of from 1 to 5.
<8> The method of producing a boron nitride particle according to any one of <5> to <7>, wherein the produced boron nitride particle has an average particle diameter of from 50 nm to 10 µm.
<9> The method of producing a boron nitride particle according to any one of <5> to <8>, wherein the shell of the produced boron nitride particle has a thickness of from 1 nm to 50 nm.
<10> The method of producing a boron nitride particle according to any one of <1> to <9>, wherein the produced boron nitride particle has an aspect ratio of from 1 to 5.
<11> The method of producing a boron nitride particle according to any one of <1> to <10>, wherein in the step of nitriding a boron-containing particle, no components other than the boron-containing particle are used, or the amount of components used other than the boron-containing particle is 5% by mass or less with respect to the boron-containing particle.
<12> A method of producing a resin composition, the method including:
   a step of producing a boron nitride particle by the method of producing a boron nitride particle according to any one of <1> to <11>, and
   a step of mixing an inorganic filler containing the produced boron nitride particle with a curable resin.
<13> The method of producing a resin composition according to <12>, wherein a further inorganic filler other than the boron nitride particle is also mixed in the mixing step.
<14> A method of producing a semiconductor device, the method including:
   a step of placing an element on a support member; and
   a step of sealing the element with a resin composition produced by the method of producing a resin composition according to <12> or <13>.
<15> A method of producing a copper-clad laminate, the method including:
   a step of producing a prepreg as a sheet by impregnating a base material with a resin composition produced by the method of producing a resin composition according to <12> or <13>; and
   a step of heating the prepreg with copper foil attached to at least one face of the prepreg.
<16> A method of producing a heat dissipation sheet, the method including a step of producing a heat dissipation sheet including a resin composition layer using a resin composition produced by the method of producing a resin composition according to <12> or <13>.
<17> A method of producing a heat dissipation device, the method including:
   a step of producing a heat dissipation sheet by the method of producing a heat dissipation sheet according to claim 16; and
   a step of placing the heat dissipation sheet between a heat generator and a heat dissipator, and pressure-bonding the heat dissipation sheet to the heat generator and the heat dissipator.

### Advantageous Effect of Invention

According to the present disclosure, a novel method of producing a boron nitride particle, whereby a boron nitride particle having low dielectric properties and high thermal conductivity can be produced, a method of producing a resin composition, which includes this method, and applications thereof can be provided.

### BRIEF DESCRIPTION OF DRAWINGS

FIG. 1 is a transmission electron micrograph of boron nitride particles in Example 1.
FIG. 2 is a transmission electron micrograph of boron nitride particles in Example 2.

### MODES FOR CARRYING OUT INVENTION

The present disclosure will be described in detail below. However, the present disclosure is not limited to the embodiments described below. In the embodiments described below, the components (including element steps and the like) are not essential unless explicitly stated as essential. The same applies to numerical values and numerical ranges, and the numerical values and ranges do not limit the present disclosure.

In the present disclosure, the term "step" includes not only a step that is independent of other steps, but also a step that cannot be clearly distinguished from other steps as long as the purpose of the step is achieved.

In the present disclosure, numerical ranges indicated using "to" include the numerical values before and after "to" as the minimum and maximum values, respectively.

When numerical ranges are described in stepwise manner in the present disclosure, the upper or lower limit value described in one numerical range may be replaced with the upper or lower limit value of another numerical range in the stepwise description. Furthermore, in any numerical range described in the present disclosure, the upper or lower limit of the numerical range may be replaced with a value indicated in the Examples.

In the present disclosure, each component may include plural substances corresponding thereto. In a case in which plural substances each corresponding to a particular component are present in a composition, the content ratio or content of the component means the total content ratio or total content of the plural substances present in the composition, unless otherwise specified.

In the present disclosure, particles corresponding to each component may include plural kinds of particles. In a case in which plural kinds of particles each corresponding to a particular component are present in a composition, the particle diameter of the component means a value obtained with respect to a mixture of the plural kinds of particles present in the composition, unless otherwise specified.

### <Method of Producing Boron Nitride Particle>

The method of producing a boron nitride particle of the present disclosure includes a step of nitriding a boron-containing particle containing boron atoms in a nitrogen gas atmosphere.

During the production of the boron nitride particle, the boron-containing particles may be subjected to, for example, heating or pressure application in a nitrogen gas atmosphere, if necessary.

In the nitriding step, the boron-containing particle may be nitrided at a pressure of from 1 to 20 atm, or a pressure of from 1 to 15 atm, or a pressure of from 5 to 15 atm. By changing the pressure for the nitriding of the boron-containing particle, the thickness of the shell formed on the boron nitride particle can be adjusted.

In the nitriding step, the boron-containing particle is preferably heated in a nitrogen gas atmosphere. The condition adopted in the case of heating is preferably from 1500°C to 2200°C, more preferably from 1600°C to 2000°C, and still more preferably from 1700°C to 1900°C.

The duration of the nitriding of the boron-containing particle in a nitrogen gas atmosphere is not particularly limited, and may be from 1 hour to 20 hours, or may be from 2 hours to 10 hours.

The boron-containing particle is not particularly limited as long as it is a particle containing boron atoms, and examples thereof include a boron particle and boron carbide.

The average particle diameter of the boron-containing particles may be from 50 nm to 10 µm, or from 100 nm to 5 µm, or from 500 nm to 3 µm, or from 1 µm to 3 µm.

The average particle diameter of the boron-containing particles may be a volume average particle diameter, and can be measured as a volume average particle diameter (D50) using, for example, a laser diffraction scattering particle diameter distribution measuring device.

The aspect ratio of the boron-containing particles may be from 1 to 5, or from 1 to 3.

The aspect ratio of the boron-containing particles can be determined, for example, using a scanning electron microscope. The aspect ratio is determined by randomly selecting 100 boron-containing particles, measuring A/B, where A is the length in the major axis direction and B is the length in the minor axis direction, and then averaging the measured A/B values.

The specific surface area of the boron-containing particles may be from 0.3 m²/g to 100 m²/g, or from 0.6 m²/g to 50 m²/g, or from 2 m²/g to 50 m²/g, or from 10 m²/g to 30 m²/g.

The specific surface area of the boron-containing particles can be measured by the BET method (nitrogen gas adsorption method).

In the step of nitriding a boron-containing particle, components other than boron-containing particles (other components) may be used. Alternatively, the boron-containing particle may contain such other components inside thereof or on the surface thereof. Examples of the other components include metals such as Fe, Ni, Mg, Cr, Al, Na, Ca, Li, Y, and Ce, and compounds containing these metals (e.g., oxides).

In the step of nitriding a boron-containing particle, no components other than boron-containing particles need to be used, and in a case in which components other than boron-containing particles are used, the content of the components may be 5% by mass or less, or 3% by mass or less, or 1% by mass or less with respect to boron-containing particles.

The nitrogen gas atmosphere is preferably an inert gas containing nitrogen gas as the main component. The inert gas may contain components other than nitrogen gas (e.g., oxygen gas) as long as the effects of the invention are achieved.

In the nitriding step, it is preferable to supply boron-containing particles to a reactor such as an electric furnace or a heating furnace, and to heat and pressurize the reactor in which the boron-containing particles are placed in a state in which the reactor is filled with an inert gas containing nitrogen gas.

The boron nitride particle produced by the production method of the present disclosure includes a core that contains boron nitride and a shell that covers at least a part of the core and contains boron nitride, and the core and the shell may have anisotropy. As the boron nitride constituting the core and the shell has anisotropy, a boron nitride particle having plural properties can be obtained, for example, a boron nitride particle having high thermal conductivity and having high flowability or high strength can be obtained.

In the boron nitride particle produced by the production method of the present disclosure, the core preferably contains boron nitride oriented along a direction intersecting the outer periphery of the particle, and the shell preferably contains boron nitride oriented along the outer periphery of the particle. This allows the boron nitride constituting the core and the shell to have anisotropy. More specifically, since boron nitride is oriented in the core along a direction intersecting the outer periphery of the particle, the particle tends to have high isotropic thermal conductivity. Furthermore, since boron nitride in the shell is oriented along the outer periphery of the particle, the specific surface area of the particle can be reduced, and, when the particle is mixed with a resin component such as a curable resin, the resultant composition tends to have excellent fluidity.

The boron nitride particle produced by the production method of the present disclosure is not a secondary particle formed by agglomeration of scale-shaped boron nitride particles, and is therefore compatible with miniaturization of semiconductor devices and narrowing of gaps in semiconductor devices. The boron nitride particle produced by the production method of the present disclosure is preferably not a secondary particle formed by agglomeration of boron nitride particles, but a primary particle including at least a core and a shell.

The boron nitride particle is applicable in the fields requiring low dielectric properties and high thermal conductivity, and also applicable to applications, such as sealing materials, in which flowability, miniaturization, and narrowing of gaps are required.

The boron nitride particle can be applied to sealing materials, interlayer insulating materials, copper-clad laminates, heat dissipation sheets, and molded products, and the like.

The shape of the boron nitride particle is preferably spherical or polyhedral from the viewpoint of flowability, and filling properties, and the like when a resin composition is prepared using the boron nitride particle.

The shape of the boron nitride particle is preferably spherical. The spherical boron nitride particle may have an aspect ratio of, for example, from 1 to 5, as described below.

The core contains boron nitride oriented along a direction intersecting the outer periphery of the boron nitride particle. In the core, radially oriented boron nitride, forming a layer, may be provided, or randomly-oriented boron nitride, forming a layer, may be provided. Regarding the boron nitride in the core, layer-forming boron nitride may be continuous in the radial direction (in a diagonal direction in the case of a polyhedron shape), or plural layers of boron nitride may be arranged discontinuously in the radial direction (in a diagonal direction in the case of a polyhedron shape).

It is preferable that the shell covers at least a part of the core and contains boron nitride oriented along the outer periphery of the particle. The shell may be a layer in which plural layers of boron nitride, each oriented along the outer periphery of the particle, are provided. Plural layers of boron nitride, each oriented along the outer periphery of the particle, may be arranged discontinuously.

The average particle diameter of the boron nitride particles may be from 50 nm to 10 µm, or from 100 nm to 8 µm, or from 1 µm to 6 µm, or from 2 µm to 6 µm.

The average particle diameter of the boron nitride particles may be a volume average particle diameter, and can be measured as a volume average particle diameter (D50) using, for example, a laser diffraction scattering particle diameter distribution measuring device.

The aspect ratio of the boron nitride particles may be from 1 to 5 or from 1 to 3.

The aspect ratio of the boron nitride particles can be determined, for example, using a scanning electron microscope. It is determined by randomly selecting 100 boron nitride particles, measuring A/B, where A is the length in the major axis direction and B is the length in the minor axis direction, and then averaging the measured A/B values.

The specific surface area of the boron nitride particles may be from 0.3 m²/g to 100 m²/g, or from 0.6 m²/g to 50 m²/g, or from 2 m²/g to 50 m²/g, or from 12 m²/g to 30 m²/g.

The specific surface area of the boron nitride particles can be measured by the BET method (nitrogen gas adsorption method).

The ratio of the specific surface area of the boron nitride particles to the specific surface area of the boron-containing particles (specific surface area of boron nitride particles/specific surface area of boron-containing particles) may be from 0.5 to 2, or from 0.7 to 1.5, or from 0.8 to 1.2.

The thickness of the shell may be from 1 nm to 50 nm, or from 3 nm to 40 nm, or from 5 nm to 30 nm. The thickness of the shell can be adjusted, for example, by changing the pressure conditions for the nitriding of the boron-containing particle. From the viewpoint of the strength of the boron nitride particle, the thickness of the shell is preferably 1 nm or more. From the viewpoint of increasing the thermal conductivity of the boron nitride particle, the thickness of the shell is preferably 50 nm or less.

The thickness of the shell can be determined, for example, using a transmission electron microscope, and is the arithmetic mean value of measurements obtained at five arbitrarily selected points.

The ratio of the length of the core to the thickness of the shell (core length/shell thickness) may be from 1 to 10,000, or from 10 to 1,000, or from 50 to 1,000.

The core length/shell thickness of the boron nitride particle can be determined using, for example, a transmission electron microscope. The length of the core means the length of the major axis of the core.

### <Method of Producing Resin Composition>

The method of producing a resin composition of the present disclosure includes: a step of producing a boron nitride particle by the method of producing a boron nitride particle of the present disclosure described above; and a step of mixing an inorganic filler containing the produced boron nitride particle with a curable resin. The resin composition may be used for producing a sealing material, an interlayer insulating material, a copper-clad laminated plate, a heat dissipation sheet, or a molded body containing boron nitride particles. In particular, it can be suitably used in applications in which high thermal conductivity, low dielectric properties, and the like are required.

The curable resin is not particularly limited as long as it is a resin that is cured, for example, by heat, or active energy rays such as ultraviolet rays. Examples thereof include an epoxy resin, a phenolic resin, a melamine resin, a urea resin, an unsaturated polyester resin, an alkyd resin, a urethane resin, a vinyl resin, a polyimide resin such as a maleimide resin, a polyamide resin, a polyamideimide resin, a silicone resin, and a (meth)acrylic resin.

The resin composition may contain only one curable resin, or may contain two or more thereof.

The resin composition of the present disclosure may contain the boron nitride particle of the present disclosure (a boron nitride particle produced by the method of producing a boron nitride particle of the present disclosure; the same applies hereinafter) and a component (also referred to as an "other component") other than curable resins. Examples of the other component include an inorganic filler other than the boron nitride particle, a thermoplastic resin, an initiator, a coupling agent, an ion exchanger, a mold release agent, a flame retardant, a colorant, a stress relaxation agent, a curing accelerator, a curing agent, a polymerization inhibitor, and a solvent.

The resin composition of the present disclosure may further contain an inorganic filler (also referred to as an "other inorganic filler") other than boron nitride particles. Examples of the other inorganic filler include silica, alumina, magnesium oxide, calcium carbonate, zirconium silicate, calcium silicate, silicon nitride, aluminum nitride, beryllia, zirconia, zircon, fosterite, steatite, spinel, mullite, titania, talc, clay, mica, aluminum hydroxide, magnesium hydroxide, a composite metal hydroxide such as a composite hydroxides of magnesium and zinc, and zinc borate.

The resin composition may contain only one other inorganic filler, or may contain two or more other inorganic fillers.

The resin composition of the present disclosure may contain a boron nitride particle (also referred to as an "other boron nitride particle") other than the boron nitride particle of the present disclosure, or may be free of such other boron nitride particles. Examples of the other boron nitride particle include a boron nitride particle obtained by a method other than the method of producing a boron nitride particle of the present disclosure. The other boron nitride particle may have an aspect ratio of more than 5.

The content ratio of the boron nitride particles of the present disclosure may be 50% by mass or more, or 70% by mass or more, or 90% by mass or more, with respect to the total content of boron nitride particles.

The upper limit of the content ratio of the boron nitride particles of the present disclosure may be 100% by mass or less, or may be 95% by mass or less, with respect to the total content of boron nitride particles.

In a case in which the resin composition of the present disclosure contains another inorganic filler, the mixing ratio of the boron nitride particles of the present disclosure to other inorganic fillers is not particularly limited, and may appropriately be adjusted in accordance with the application, required physical properties, and the like.

For example, the content ratio of the boron nitride particles of the present disclosure may be from 10% by mass to 90% by mass, or from 20% by mass to 80% by mass, or from 30% by mass to 70% by mass, with respect to the total content of the boron nitride particles of the present disclosure and other inorganic fillers.

The content of boron nitride particles in the resin composition of the present disclosure may be from 5% by volume to 95% by volume, or from 10% by volume to 90% by volume, or from 10% by volume to 50% by volume, or from 50% by volume to 90% by volume.

### (Semiconductor Device)

The resin composition may be used in production of a semiconductor device. For example, a semiconductor device may include a support member, an element disposed on the support member, and a cured product of the resin composition of the present disclosure, which seals the element.

The semiconductor device described above can be produced by, for example, a method of producing a semiconductor device, the method including: a step of placing an element on a support member; and a step of sealing the element with a resin composition produced by the method of producing a resin composition of the present disclosure.

### (Copper-clad Laminate)

The resin composition can be used for producing a laminate including a prepreg sheets layered one on another, each prepreg sheet being a sheet including a base material, such as paper or glass, impregnated with a resin. A copper-clad laminate can be produced by applying copper foil to both sides of the laminate. For example, the copper-clad laminate may include a prepreg that is a sheet in which a base material is impregnated with the resin composition, and copper foil provided on at least one face of the prepreg, preferably on both faces of the prepreg.

The copper-clad laminate can be produced by a method of producing a copper-clad laminate, the method including: a step of producing a prepreg as a sheet by impregnating a base material with a resin composition produced by the method of producing a resin composition of the present disclosure; and a step of heating the prepreg with copper foil attached to at least one face of the prepreg.

### (Heat Dissipation Sheet)

A heat dissipation sheet may be produced using the resin composition. The heat dissipation sheet includes a resin composition layer containing the resin composition. The heat dissipation sheet may be a laminated body in which the resin composition layer is disposed on a support. A heat dissipation device may be prepared which includes a heat generator, a heat dissipator, and a resin composition layer containing the resin composition, the resin composition layer being disposed between the heat generator and the heat dissipator.

The above-described heat dissipation sheet can be produced by a method of producing a heat dissipation sheet, the method including a step of producing a heat dissipation sheet including a resin composition layer using a resin composition produced by the method of producing a resin composition of the present disclosure.

The above-described heat dissipation device can be produced by a method of producing a heat dissipation device, the method including: a step of producing a heat dissipation sheet by the method of producing a heat dissipation sheet of the present disclosure; and a step of placing the heat dissipation sheet between a heat generator and a heat dissipator and pressure-bonding the heat dissipation sheet to the heat generator and the heat dissipator.

### EXAMPLES

### [Example 1]

Boron particles (average particle diameter: 1.4 µm; BET specific surface area: 13.4 m²/g; aspect ratio: from 1.0 to 4.8) were prepared as a raw material for boron nitride particles. The boron particles were allowed to react in a nitrogen gas atmosphere at 1 atm and 1750°C for 4 hours. As a result, boron nitride particles were obtained, which included: a core that contained boron nitride oriented along a direction intersecting the outer periphery of the particle, and a shell that covered at least a part of the core and contained boron nitride oriented along the outer periphery of the particle.

### [Example 2]

Boron nitride particles were produced in the same manner as that in Example 1, except that the pressure during reaction of the boron particles was changed to 10 atm.

### [Comparative Example 1]

### (Scale-shaped Boron Nitride Particles)

A mixture of 40 g of boric acid, 20 g of melamine, and 10 g of water was stirred and mixed, and then placed in a mold and pressed, thereby obtaining a molded body having a density of 0.7 g/cm³. This molded body was dried in a dryer at 300°C for 8 hours, and then pre-baked at 1 atm and 1100°C for 4 hours under an ammonia gas atmosphere at . The pre-baked product was then pulverized, thereby obtaining a crude boron nitride powder.

The crude boron nitride powder was fired at 1 atm and 1750°C under a nitrogen gas atmosphere for a total of 4 hours, and the fired product was then washed with warm water at 60°C, thereby obtaining scale-shaped boron nitride particles.

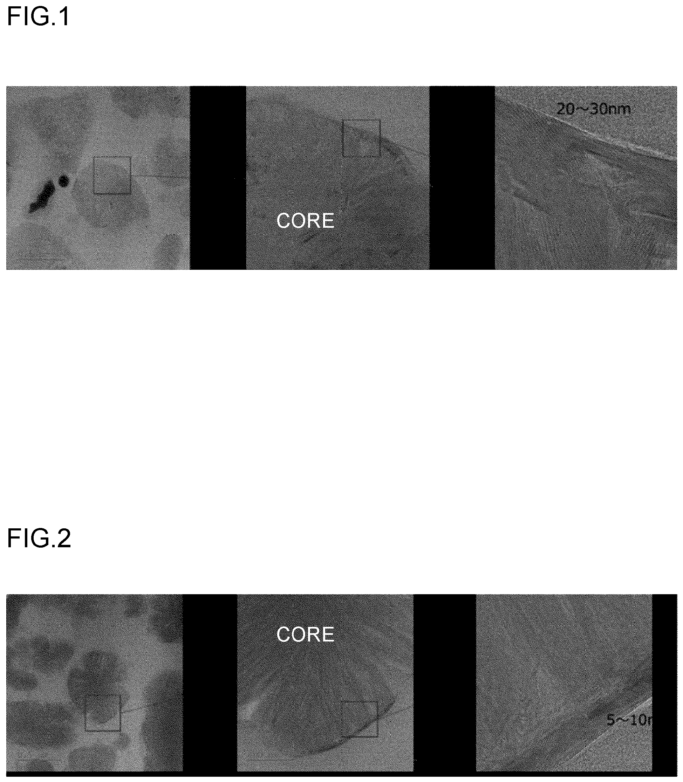

The boron nitride particles obtained in Examples 1 and 2 are shown in FIGS. 1 and 2 and Table 1. The aspect ratios in the table each represent a range from the minimum value to the maximum value of aspect ratios plural boron-containing particles obtained by measurement using a scanning electron microscope. The average particle diameters in the table are volume average particle diameters (D50) measured using a laser diffraction scattering particle diameter distribution measuring device. The particle diameter ranges in the table indicate the minimum and maximum particle diameters observed with a transmission electron microscope. As shown in FIGS. 1 and 2, the boron nitride particles obtained had a core having boron nitride oriented along a direction intersecting the outer periphery of the particle, and a shell having boron nitride oriented along the outer periphery of the particle. The thickness of the shell was adjustable by changing the pressure during the nitriding of the boron particles.

**Table 1**

| | Example 1 | Example 2 | Comparative Example 1 |
|---|---|---|---|
| Shell Thickness (nm) | 20-30 | 5-10 | - |
| Average particle diameter (nm) | 3500 | 5200 | 1200 |
| Particle diameter range (nm) | 100-5500 | 100-7100 | 200-1800 |
| Aspect ratio | 1.0-4.3 | 1.0-4.7 | 5.2-14.5 |
| Specific surface area (m²/g) | 14.4 | 12.3 | 11.0 |

The disclosure of Japanese Patent Application No. 2023-213371, filed on December 18, 2023, is incorporated herein by reference in its entirety.

All publications, patent applications, and technical standards mentioned in this specification are incorporated herein by reference to the same extent as if each publication, patent application, or technical standard were specifically and individually indicated to be incorporated by reference.

## Claims

1. A method of producing a boron nitride particle, the method comprising a step of nitriding a boron-containing particle containing boron atoms in a nitrogen gas atmosphere.

2. The method of producing a boron nitride particle according to claim 1, wherein the boron-containing particle is nitrided at a pressure of from 1 to 20 atm.

3. The method of producing a boron nitride particle according to claim 1, wherein the boron-containing particle is nitrided under heating conditions of from 1500°C to 2200°C.

4. The method of producing a boron nitride particle according to claim 1, wherein the boron-containing particle includes at least one selected from the group consisting of a boron particle and boron carbide.

5. The method of producing a boron nitride particle according to claim 1, wherein the produced boron nitride particle comprises a core that contains boron nitride and a shell that covers at least a part of the core and contains boron nitride, and the core and the shell have anisotropy.

6. The method of producing a boron nitride particle according to claim 5, wherein:
the core contains boron nitride oriented in a direction intersecting an outer periphery of the particle; and
the shell contains boron nitride oriented along the outer periphery of the particle.

7. The method of producing a boron nitride particle according to claim 1, wherein the boron-containing particle has an aspect ratio of from 1 to 5.

8. The method of producing a boron nitride particle according to claim 5, wherein the produced boron nitride particle has an average particle diameter of from 50 nm to 10 µm.

9. The method of producing a boron nitride particle according to claim 5, wherein the shell of the produced boron nitride particle has a thickness of from 1 nm to 50 nm.

10. The method of producing a boron nitride particle according to claim 7, wherein the produced boron nitride particle has an aspect ratio of from 1 to 5.

11. The method of producing a boron nitride particle according to claim 1, wherein, in the step of nitriding a boron-containing particle, no components other than the boron-containing particle are used, or an amount of components used other than the boron-containing particle is 5% by mass or less with respect to the boron-containing particles.

12. A method of producing a resin composition, the method comprising:
a step of producing a boron nitride particle by the method of producing a boron nitride particle according to any one of claims 1 to 11; and
a step of mixing an inorganic filler containing the produced boron nitride particle with a curable resin.

13. The method of producing a resin composition according to claim 12, wherein a further inorganic filler other than the boron nitride particle is also mixed in the mixing step.

14. A method of producing a semiconductor device, the method comprising:
a step of placing an element on a support member; and
a step of sealing the element with a resin composition produced by the method of producing a resin composition according to claim 12.

15. A method of producing a copper-clad laminate, the method comprising:
a step of producing a prepreg as a sheet by impregnating a base material with a resin composition produced by the method of producing a resin composition according to claim 12; and
a step of heating the prepreg with copper foil attached to at least one face of the prepreg.

16. A method of producing a heat dissipation sheet, the method comprising a step of producing a heat dissipation sheet comprising a resin composition layer using a resin composition produced by the method of producing a resin composition according to claim 12.

17. A method of producing a heat dissipation device, the method comprising:
a step of producing a heat dissipation sheet by the method of producing a heat dissipation sheet according to claim 16; and
a step of placing the heat dissipation sheet between a heat generator and a heat dissipator, and pressure-bonding the heat dissipation sheet to the heat generator and the heat dissipator.
